# EUROPEAN PATENT APPLICATION

(11) **EP 4 645 406 A1**
(43) Date of publication of application: **05.11.2025**
(21) Application number: 25168971.7
(22) Date of filing: 07.04.2025
(51) Int. Cl.: H01M 4/04, H01M 4/133, H01M 4/1393, H01M 4/62, H01M 10/052, H01M 4/02

(54) **NEGATIVE ELECTRODE FOR RECHARGEABLE LITHIUM BATTERY, METHOD OF PREPARING NEGATIVE ELECTRODE, AND RECHARGEABLE LITHIUM BATTERY INCLUDING NEGATIVE ELECTRODE**

(30) Priority: 09.04.2024 KR 20240048181
(71) Applicant: SAMSUNG SDI CO., LTD., Yongin-si, Gyeonggi-do 17084 (KR); IUCF-HYU (Industry-University Cooperation Foundation Hanyang University), Seoul 04763 (KR)
(72) Inventor: LEE, Jinhyon, 17084 Yongin-si (KR); PAIK, Ungyu, 06289 Seoul (KR); SONG, Taeseup, 03180 Seoul (KR); KIM, Jiwoon, 02858 Seoul (KR); KIM, Minsung, 02782 Seoul (KR)
(74) Representative: Marks & Clerk LLP

(57) **Abstract**

A negative electrode for a rechargeable lithium battery and a rechargeable lithium battery including the negative electrode are provided. The negative electrode includes a dry negative active material layer including a negative active material and a polytetrafluoroethylene binder that includes a N-including protection layer.

## Description

### BACKGROUND

### (a) Field

Embodiments relate to a negative electrode for a rechargeable lithium battery, a method of preparing the negative electrode, and a rechargeable lithium battery including the negative electrode.

### (b) Description of the Related Art

A rechargeable lithium battery exhibits excellent discharge voltage and high energy density. Recently, as the rechargeable battery industry required for electric vehicles has developed, the need for rechargeable lithium batteries with higher energy density has increased. To improve energy density of a rechargeable lithium battery, a thick film electrode has been attempted. However, if the electrode is prepared by the generally used wet procedure, binder migration occurs during the drying, which results in microstructure deterioration, thereby making it impossible to sufficiently thicken the electrode.

Thus, methods for preparing rechargeable lithium batteries using a dry process have been researched.

### SUMMARY

One or more embodiments of the present disclosure provide a negative electrode for a rechargeable lithium battery that has excellent electrochemical performance.

Another embodiment provides a method of preparing the negative electrode.

Still another embodiment provides a rechargeable lithium battery including the negative electrode.

One or more embodiments provide a negative electrode for a rechargeable lithium battery including a dry negative active material layer including a negative active material and a polytetrafluoroethylene binder that includes a N-including protection layer.

Another embodiment provides a method of preparing the negative electrode for a rechargeable lithium battery including mixing a negative active material with polytetrafluoroethylene and fibrillating the mixture to prepare a fibrillated product; compressing the fibrillated product to prepare a dry film; subjecting the dry film to a vapor reaction to prepare a negative active material layer; and positioning the negative active material layer on a current collector.

Still another embodiment provides a rechargeable lithium battery including the negative electrode; a positive electrode; and a non-aqueous electrolyte.

At least some of the above and other features of the invention are set out in the claims.

Other embodiments are included in the following detailed description.

A negative electrode for a rechargeable lithium battery according to one or more embodiments may provide a battery exhibiting excellent initial efficiency and cycle-life characteristic.

### BRIEF DESCRIPTION OF THE DRAWINGS

FIG. 1 is a schematic view for preparing a protection layer in a negative electrode according to one or more embodiments.
FIG. 2 to FIG. 5 are schematic views showing rechargeable lithium batteries according to one or more embodiments.
FIG. 6 is a graph showing the initial efficiency of the half-cells according to Example 1 and Comparative Example 1.
FIG. 7 is a graph showing cycle-life characteristic of the half-cells according to Examples 1 to 3 and Comparative Example 1.
FIG. 8 is a graph showing coulombic efficiency of the half-cell according to Examples 1 to 3 and Comparative Example 1.
FIG. 9 is a graph showing cycle-life characteristic of the half-cells according to Examples 1, 4, and 5, and Comparative Example 1.
FIG. 10 is a graph showing coulombic efficiency of the half-cells according to Examples 1, 4, and 5, and Comparative Example 1.
FIG. 11 is a graph showing an XPS measurement result for the negative electrode of Comparative Example 1.
FIG. 12 is a graph showing an XPS measurement result for the negative electrode of Comparative Example 2.
FIG. 13 is a graph showing an XPS measurement result for the negative electrode of Example 1.
FIG. 14 is a graph showing an XPS measurement result for the negative electrode of Example 2.
FIG. 15 is a graph showing an XPS measurement result for the negative electrode of Example 3.
FIG. 16 is a graph showing an XPS measurement result for the negative electrode of Example 4.
FIG. 17 is a graph showing an XPS measurement result for the negative electrode of Example 5.

### DETAILED DESCRIPTION

Hereinafter, embodiments are described in detail. However, the present disclosure is not limited to these embodiments.

Terms are used in the specification to explain embodiments, but the terminology does not necessarily limit the scope of the present disclosure. Expressions in the singular include expressions in plural unless the context clearly dictates otherwise.

The term "combination thereof" may include a mixture, a laminate, a complex, a copolymer, an alloy, a blend, a reactant of constituents.

The terms "comprise," "include," or "have" are intended to designate that the performed characteristics, numbers, step, constituted elements, or a combination thereof is present, but it should be understood that the possibility of presence or addition of one or more other characteristics, numbers, steps, constituted elements, or a combination are not to be precluded in advance.

The drawings show that the thickness is enlarged in order to clearly show the various layers and regions, and the same reference numerals are given to similar parts throughout the specification. When an element, such as a layer, a film, a region, a plate, and the like is referred to as being "on" or "over" another part, it may include cases where it is "directly on" another element, but also cases where there is another element in between. In contrast, when an element is referred to as being "directly on" another element, there are no intervening elements present.

In addition, herein, "layer" includes a shape totally formed on the entire surface or a shape partial surface, when viewed from a plane view.

Herein, "or" is not to be construed as an exclusive meaning, for example, "A or B" is construed to include A, B, A+B, and the like.

Unless otherwise defined in the specification, particle diameter or size may be an average particle diameter. An average particle diameter indicates an average particle diameter (D50) where a cumulative volume is about 50 volume% in a particle size distribution. The particle size (D50) may be measured by a method well known to those skilled in the art, for example, by a particle size analyzer, or by a transmission electron microscopic image, or a scanning electron microscopic image. Alternatively, a dynamic light-scattering measurement device is used to perform a data analysis, and the number of particles is counted for each particle size range, and from this, the average particle diameter (D50) value may be easily obtained through a calculation.

In some embodiments, an average particle diameter may be measured by various techniques, and, for example, may be measured by a particle size analyzer.

In some embodiments, a thickness may be measured by a scanning electron microscope (SEM) or a transmission electron microscope (TEM) image for the cross-section, but is not limited thereto, and the thickness may be measured by techniques in the related arts. The thickness may be an average thickness.

As used herein, soft carbon refers to graphitizable carbon materials that are readily graphitized by heat treatment at a high temperature, e.g., about 2800 °C. Hard carbon refers to non-graphitizable carbon materials and are not substantially and slightly graphitized by heat treatment. The terms soft carbon and hard carbon may be well known in the related arts.

In some embodiments, the crystalline carbon and the amorphous carbon may be distinguished through X-ray diffraction (XRD) measurement. The crystalline carbon includes natural graphite and artificial graphite. Natural graphite may indicate graphite that may be naturally generated by separating it from minerals, and if measured by XRD, the interplanar spacing (d002) of the (002) plane may be about 3.350 Å to about 3.360 Å. Artificial graphite may indicate graphite manufactured by graphitization, and if measured by XRD, the interplanar spacing (d002) of the (002) plane may be about 3.355 Å to about 3.365 Å. Amorphous carbon may have the interplanar spacing (d002) of the (002) plane of about 3.34 Å or less, if measured by XRD. The XRD may be measured using CuKα ray as a target line with an X-ray diffraction analyzer (e.g., product name: X'Pert, manufacturer: Malvern Panalytical) and by removing a monochromator to improve a peak density resolution. The measurement condition may be 2θ = 10° to 80°, a scan speed (°/S) of 0.044 to 0.089, and a step size (°/step) of 0.013 to 0.039.

A negative electrode for a rechargeable lithium battery according to one or more embodiments includes a dry negative active material layer including a negative active material and a polytetrafluoroethylene binder that includes a N-including protection layer. Such a negative electrode refers to a negative electrode prepared by a dry process using no solvents in a negative active material layer preparation, in other words, not a wet process.

The binder according to one or more embodiments is a protection layer that is formed as polytetrafluoroethylene and the protection layer including an N-element is formed on the surface of the polytetrafluoroethylene. The protection layer includes the N-element, e.g., a N-including protection layer may further include C (carbon), O (oxygen), H (hydrogen) element, or a combination thereof.

The N-including protection layer may include a N-including functional group. The N-including functional group may be an imide group, an amide group, an amine group, a nitrile group, or a combination thereof. The inclusion of such N-including functional group in the N-including protection layer may be confirmed by a binding energy of the negative electrode measured using an X-ray photoelectron spectroscopy (XPS) for the negative electrode. For example, a peak appearing at a binding energy of about 399.0 eV to about 400 eV may indicate the presence of an amide group and a peak appearing at a binding energy of about 400.4 eV to about 401 eV may indicate the presence of an imide group. The peak appearing at a binding energy of about 397 eV to 400.2eV may indicate the presence of an amine group or a nitrile group.

In one or more embodiments, the XPS measurement may be carried out by cutting the negative electrode at a predetermined size, e.g., about 0.5 X 0.5 cm², adhering it on a carbon tape, attaching the resultant to a substrate on a vacuum holder, irradiating an Al Ka X-ray, with a photon energy (hv) thereto, and measuring a binding energy (BE) from a kinetic energy of a photo electron emitted therefrom.

The N-including protection layer may suppress a side reaction of polytetrafluoroethylene and enhance the mechanical strength of the negative electrode. Polytetrafluoroethylene has low LUMO (lowest unoccupied molecular orbital) level, which results in low reduction resistance, if it is utilized in the negative electrode. Thus, a side reaction may occur, thereby deteriorating the binding characteristics, decreasing the initial efficiency of the electrode, and resulting in irreversible capacity. In one or more embodiments, the N-including protection layer may improve the resistance to the reduction of polytetrafluoroethylene, thereby preventing side reactions when the polytetrafluoroethylene is used in the negative electrode. Thus, while the mechanical properties of the negative electrode are maintained, the initial efficiency and cycle-life characteristics may be enhanced.

The negative electrode according to one or more embodiments relates to a dry negative electrode such that the dry negative active material layer may have a thickness of about 10 µm to about 400 µm, about 100 µm to about 250 µm, or about 120 µm to about 180 µm, and may be a thick layer. This may provide a negative electrode exhibiting excellent energy density.

If the entire surface of the negative active material layer is covered with the N-including protection layer, the conductivity is deteriorated. But in one or more embodiments, as the N-including protection layer is formed on the surface of polytetrafluoroethylene, the entire surface of the negative active material layer is not substantially covered by the N-including protection layer.

In one or more embodiments, the negative active material may include a N-including protection layer. For example, a N-including protection may be formed on the surface of the negative active material. If N-including protection layers are formed on both the polytetrafluoroethylene binder and the negative active material, side reactions with the polytetrafluoroethylene may be effectively adjusted and the interface resistance of the active material may be also reduced.

A thickness of the N-including protection layer may be about 0.1 nm to about 30 nm, about 0.5 nm to about 20 nm, about 1 nm to about 10 nm, or about 1 nm to about 3 nm. If the thickness of the N-including protection layer is in these ranges, side reactions of polytetrafluoroethylene may be effectively prevented and the initial efficiency may be more enhanced. The thickness may be an average thickness. In one or more embodiment, the thickness may be measured by SEM or TEM.

In one or more embodiments, an amount of the N-including protection layer may be, based on 100 wt% of the polytetrafluoroethylene, about 1 wt% to about 50 wt%, about 2 wt% to about 30 wt%, or about 5 wt% to about 10 wt%. If the amount of the N-including protection layer is within these ranges, side reactions of polytetrafluoroethylene may be further effectively controlled.

In one or more embodiments, an amount of the polytetrafluoroethylene binder on which the N-including protection layer is formed may be, based on 100 wt% of the negative active material layer, about 0.1 wt% to about 50 wt%, about 0.1 wt% to about 20.0 wt%, about 1 wt% to about 10 wt%, or about 1 wt% to about 5 wt%. If the amount of the binder is within these ranges, the mechanical properties of the negative electrode may be well maintained, the negative active materials may be well attached each other, and the negative active material layer may remain firmly attached to the current collector.

In one or more embodiments, the dry negative active material layer may further include a non-fibrillated binder. The non-fibrillated binder may be, for example, carboxymethyl cellulose, a styrene-butadiene rubber, polyvinylidene fluoride, polyacrylic acid, or a combination thereof. The N-including protection layer may or may not be formed on the surface of the non-fibrillated binder.

If the dry negative active material layer includes the non-fibrillated binder, a mixing ratio of the polytetrafluoroethylene binder that includes the N-including protection layer and the non-fibrillated binder may be about 1:5 to about 1:1 by weight ratio, or about 1:5 to about 1:2 by weight ratio. If the mixing ratio of the N-including protection layer including polytetrafluoroethylene and the non-fibrillated binder is within these ranges, adherence between the negative active materials and to current collector may be strengthened, and mechanical properties of the negative electrode may be maintained.

The polytetrafluoroethylene binder that includes the N-including protection layer may be fibrillated.

The negative active material includes a material that reversibly intercalates/deintercalates lithium ions, a lithium metal, a lithium metal alloy, a material capable of doping/dedoping lithium, or a transition metal oxide.

The material that reversibly intercalates/deintercalates lithium ions may be a carbon material such as crystalline carbon, amorphous carbon, or a combination thereof. The crystalline carbon may be unspecified shaped, sheet, flake, spherical, or fiber shaped natural graphite or artificial graphite. The amorphous carbon may be a soft carbon, a hard carbon, a mesophase pitch carbonization product, fired coke, and the like.

The lithium metal alloy includes an alloy of lithium and a metal selected from Na, K, Rb, Cs, Fr, Be, Mg, Ca, Sr, Si, Sb, Pb, In, Zn, Ba, Ra, Ge, Al, and Sn.

The material capable of doping/dedoping lithium may be a silicon-based negative active material, or a Sn-based negative active material. The Si-based negative active material may be silicon, a Si-C composite, SiOₓ (0 < x < 2), a Si-Q alloy (wherein Q is an element selected from an alkali metal, an alkaline-earth metal, a Group 13 element, a Group 14 element (except for Si), a Group 15 element, a Group 16 element, a transition metal, a rare earth element, or a combination of such materials. The Sn-based negative active material may be Sn, SnO₂, a Sn-based alloy, or a combination of such materials.

The silicon-carbon composite may be a composite of silicon and amorphous carbon. According to one or more embodiments, the silicon-carbon composite may include silicon particles and an amorphous carbon coated on the surfaces of the silicon particles. The silicon-carbon composite may include secondary particles in which silicon primary particles are agglomerated and an amorphous carbon coating layer formed on the secondary particles. The amorphous carbon is positioned between the silicon primary particles, for example, coating the silicon primary particles. The secondary particles may be added by distributing them in an amorphous carbon matrix.

The silicon-carbon composite may further include crystalline carbon. The silicon-carbon composite may include a core including crystalline carbon and silicon particles, and an amorphous carbon coating layer on the surface of the core.

The silicon particles may be silicon nano particles.

A particle diameter of the silicon nano particles may be about 10 nm to about 1000 nm, or, according to other embodiments, may be about 10 nm to about 200 nm, or about 20 nm to about 150 nm. If the particle diameter of the silicon nano particles is within these ranges, extreme volume expansion caused during charge and discharge may be suppressed, and breakage of the conductive path due to crushing of particles may be prevented.

In the negative active material according to one or more embodiments, the silicon-carbon composite may include silicon nano particles as a core and an amorphous carbon coating layer on the surfaces of the silicon nano particles. The silicon-carbon composite may include an agglomerated product where silicon nano particles are agglomerated and an amorphous carbon coating layer is formed on the surface of the agglomerated product.

In the amorphous carbon coating layer, the amorphous carbon may be soft carbon, hard carbon, mesophase pitch carbide, sintered cokes, or a combination of these materials. A thickness of the amorphous carbon coating layer may be about 1 nm to about 2 µm, about 1 nm to about 500 nm, about 10 nm to about 300 nm, or about 20 nm to about 200 nm. If the thickness of the amorphous carbon coating layer is within these ranges, the volume expansion of silicon may be effectively suppressed during charging and discharging.

The crystalline carbon may be graphite such as unspecified shape, sheet, flake, spherical or fiber shaped natural graphite, or artificial graphite.

If the silicon-carbon composite includes silicon nano particles and an amorphous carbon coating layer, based on the total 100 wt% of the silicon-carbon composite, an amount of the silicon nano particles may be about 30 wt% to about 70 wt%, or about 40 wt% to about 65 wt%. An amount of the amorphous carbon coating layer may be, based on the total 100 wt% of the silicon-carbon composite, about 30 wt% to about 70 wt%, or about 35 wt% to about 60 wt%.

In the case where the crystalline carbon is included in the silicon-carbon composite, based on the total 100 wt% of the silicon-carbon composite, an amount of the silicon nano particles may be about 20 wt% to about 70 wt%, or about 25 wt% to about 65 wt%. Based on the total 100 wt% of the silicon-carbon composite, an amount of the amorphous carbon may be about 25 wt% to about 70 wt%, or about 25 wt% to about 60 wt%, and an amount of the crystalline carbon may be about 1 wt% to about 20 wt%, or about 5 wt% to about 15 wt%.

An amount of the negative active material may be, based on the total 100 wt% of the negative active material layer, about 0.1 wt% to about 99.9 wt%, or about 60 wt% to about 99 wt%.

The negative active material layer may further include a conductive material. An amount of the conductive material may be, based on the total 100 wt% of the negative active material layer, more than 0 wt% and about 10 wt% or less. The conductive material is included to provide electrode conductivity, and any electrically conductive material may be used as a conductive material provided that it does not cause a chemical change. Examples of the conductive material include a carbon-based material such as natural graphite, artificial graphite, carbon black, acetylene black, ketjen black, a carbon fiber, a carbon nanofiber, carbon nanotubes, and the like; a metal-based material of a metal powder or a metal fiber including copper, nickel, aluminium, silver, and the like; a conductive polymer such as a polyphenylene derivative, or mixtures of such materials.

A negative electrode according to one or more embodiments includes a current collector to support the negative active material layer.

The current collector may include a copper foil, a nickel foil, a stainless steel foil, a titanium foil, a nickel foam, a copper foam, a polymer substrate coated with a conductive metal, and combination of such materials.

### <Method of preparing negative electrode>

A negative active material is mixed with polytetrafluoroethylene and fibrillated to prepare a fibrillated product. A mixing ratio of the negative active material and polytetrafluoroethylene may be about 80:20 to about 98:2 by weight ratio, or about 94:6 to about 98:2 by weight ratio.

The fibrillation may be carried out by mixing the negative active material with polytetrafluoroethylene at a speed of about 100 rpm to about 50000 rpm, e.g., about 3000 rpm to about 14000 rpm, to generate appropriate shear force. The fibrillation may stretch the particle-shaped polytetrafluoroethylene, thereby converting it to a fiber-shape, e.g., fibrillation, and this fibrillated polytetrafluoroethylene and the negative active material may be networked together.

During the mixing, a non-fibrillated binder may be added. The non-fibrillated binder may be one or more of carboxymethyl cellulose, a styrene-butadiene rubber, polyvinylidene fluoride, and polyacrylic acid.

Also during the mixing, a conductive material may be added. If the conductive material is further added, the fibrillated polytetrafluoroethylene, the negative active material, and the conductive material may be networked together.

If the polytetrafluoroethylene is first fibrillated and the fibrillated polytetrafluoroethylene is mixed with the active material and the conductive material, network formation may not occur, thereby making it difficult to prepare a dry film.

The fibrillated product is compressed to prepare a dry film.

Thereafter, the dry film is subjected to a vapor reaction treatment to prepare a negative active material layer. The vapor reaction may be one or more of a chemical vapor deposition, a physical vapor deposition, an atomic layer deposition, and a plasma reaction.

The vapor reaction treatment may include a gas plasma treatment of the dry film and a gas nitriding. The gas plasma treatment may be carried out by using oxygen (O₂) gas, or may be carried out by using a mixture of an inert gas and oxygen. The inert gas may be one or more of an Ar gas, and a N₂ gas. If the oxygen gas and the inert gas are utilized together, a mixing ratio thereof may be about 1:10 to about 10:1 by volume ratio or about 1:3 to about 3:1 by volume ratio. The gas nitriding may be carried out by a chemical vapor deposition while flowing an ammonia (NH₃) gas.

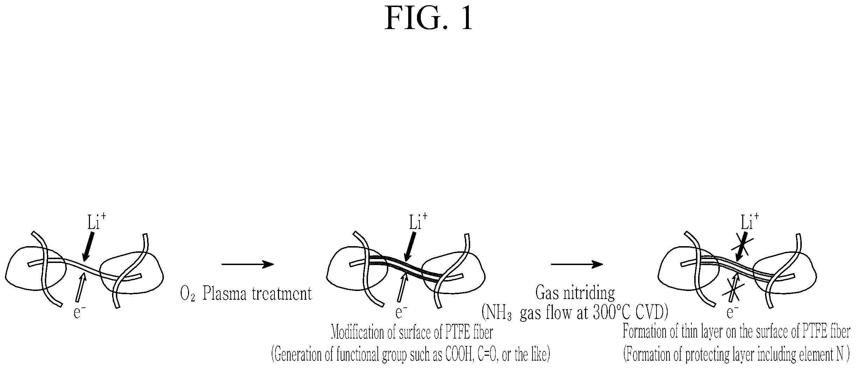

FIG. 1 schematically shows the O₂ plasma treatment carried out using oxygen gas and gas nitriding using ammonia (NH₃) gas. The nitriding shown in FIG. 1 is a chemical vapor deposition (CVD) at 300 °C using the NH₃ gas as one example, but the present disclosure is not limited thereto.

As shown in FIG. 1, if the oxygen plasma treatment is carried out on the dry film, the oxygen-including functional groups such as COOH, C=O, C-OH, CO, or combinations thereof are prepared on the surface of the binder and these oxygen-including functional groups are converted into the N-including functional groups in the gas nitriding, thereby preparing the N-including protection layer on the surface of the binder.

The gas nitriding may be carried out at about 50 °C to about 600 °C, or about 200 °C to about 320 °C. If the gas nitriding is carried out at these temperature ranges, the protection layer may be well formed and not damaged.

The gas plasma treatment may be performed for about 1 second to about 120 minutes, about 30 seconds to about 50 minutes, about 30 seconds to about 10 minutes, or about 30 second to about 5 minutes. If the gas plasma treatment is performed for these times, the oxygen-including functional groups may be prepared on the surface of the binder.

The gas nitriding may be performed for about 1 minute to about 6 hours, about 30 minutes to about 5 hours, or about 1 hour to about 4 hours. If the gas nitriding is performed for these times, the N-including functional groups may be prepared on the surface of the binder.

If the vapor reaction, e.g., the gas plasma treatment and the gas nitriding, is carried out on the binder and then the resulting binder is mixed with a negative active material and fibrillated, the binder is stretched, and while fibrillating, fresh surfaces that are not affected by the gas plasma treatment and the gas nitriding may be continuously formed. Thus, the surfaces where the vapor reaction is not carried out may exist, and, thus, the effect resulting from a protection layer on the surface of the binder may not be realized.

Thereafter, the negative active material layer is provided on a current collector, thereby preparing a negative electrode. This may be carried out by a laminate process, but the present disclosure is not limited thereto.

### <Rechargeable lithium battery>

A rechargeable lithium battery according to another embodiment includes the negative electrode, a positive electrode, and a non-aqueous electrolyte.

### < Positive electrode>

The positive electrode may include a current collector and a positive electrode active material layer on the current collector. The positive electrode active material layer includes a positive electrode active material and may further include a binder and/or a conductive material.

For example, the positive electrode may further include an additive that may serve as a sacrificial positive electrode.

The positive active material may include a compound (lithiated intercalation compound) that is capable of intercalating and deintercalating lithium. In some embodiments, one or more of a composite oxide of lithium and a metal selected from cobalt, manganese, and nickel may be used.

The composite oxide may be a lithium transition metal composite oxide, and examples thereof may include one or more lithium nickel-based oxide, lithium cobalt-based oxide, lithium manganese-based oxide, lithium iron phosphate-based compound, and cobalt-free lithium nickel-manganese-based oxide.

For example, the following compounds represented by any one of the following chemical formulas may be used: LiₐA_{1-b}X_{b}O_{2-c}D_{c} (0.90≤a≤1.8, 0≤b≤0.5, 0≤c≤0.05); LiₐMn_{2-b}X_{b}O_{4-c}D_{c} (0.90≤a≤1.8, 0≤b≤0.5, 0≤c≤0.05); LiₐNi_{1-b-c}Co_{b}X_{c}O_{2-α}D_{α} (0.90≤a≤1.8, 0≤b≤0.5, 0≤c≤0.5, 0<α<2); LiₐNi_{1-b-c}Mn_{b}X_{c}O_{2-α}D_{α} (0.90≤a≤1.8, 0≤b≤0.5, 0≤c≤0.5, 0<α<2); LiₐNi_{b}Co_{c}L¹_{d}GₑO₂ (0.90≤a≤1.8, 0≤b≤0.9, 0≤c≤0.5, 0≤d≤0.5, 0≤e≤0.1); LiₐNiG_{b}O₂ (0.90≤a≤1.8, 0.001≤b≤0.1); LiₐCoG_{b}O₂ (0.90≤a≤1.8, 0.001≤b≤0.1); LiₐMn_{1-b}G_{b}O₂ (0.90≤a≤1.8, 0.001≤b≤0.1); LiₐMn₂G_{b}O₄ (0.90≤a≤1.8, 0.001≤b≤0.1); LiₐMn_{1-g}G_{g}PO₄ (0.90≤a≤1.8, 0≤g≤0.5); Li _{(3-f)}Fe₂(PO₄)₃ (0≤f≤2); LiₐFePO₄ (0.90≤a≤1.8). In these chemical formulas, A is Ni, Co, Mn, or a combination thereof; X is Al, Ni, Co, Mn, Cr, Fe, Mg, Sr, V, a rare earth element or a combination thereof; D is O, F, S, P, or a combination thereof; G is Al, Cr, Mn, Fe, Mg, La, Ce, Sr, V, or a combination thereof; and L¹ is Mn, Al, or a combination thereof.

The positive electrode active material may be a high nickel-based positive electrode active material having a nickel amount of greater than or equal to about 80 mol%, greater than or equal to about 85 mol%, greater than or equal to about 90 mol%, greater than or equal to about 91 mol%, or greater than or equal to about 94 mol% and less than or equal to about 99 mol% based on 100 mol% of the metal excluding lithium in the lithium transition metal composite oxide. The high-nickel-based positive electrode active material may realize high capacity and may be applied to a high-capacity, high-density rechargeable lithium battery.

An amount of the positive active material may be about 90 wt% to about 99.5 wt% based on 100 wt% of the positive active material layer, and the amounts of the binder and the conductive material may be about 0.5 wt% to about 5 wt% based on 100 wt% of the positive active material layer.

The binder improves binding properties of positive electrode active material particles with one another and with a current collector. Examples of the binder are polyvinyl alcohol, carboxymethyl cellulose, hydroxypropyl cellulose, diacetyl cellulose, polyvinyl chloride, carboxylated polyvinyl chloride, polyvinyl fluoride, an ethylene oxide-containing polymer, polyvinyl pyrrolidone, polyurethane, polytetrafluoroethylene, polyvinylidene fluoride, polyethylene, polypropylene, a styrene butadiene rubber, a (meth)acrylated styrene butadiene rubber, an epoxy resin, a (meth)acrylic resin, a polyester resin, nylon, or the like, but the present disclosure is not limited to these examples.

The conductive material is included to provide electrode conductivity, and any electrically conductive material may be used as a conductive material provided that it does not cause a chemical change. Examples of the conductive material may include a carbonaceous material such as natural graphite, artificial graphite, carbon black, acetylene black, Ketjen black, carbon fiber, carbon nanofiber, carbon nanotube, or the like; a metal-based material of a metal powder or a metal fiber including copper, nickel, aluminium, silver, or the like; a conductive polymer such as a polyphenylene derivative; or a mixture of such materials.

The current collector may include Al, but is not limited thereto.

### <Electrolyte>

The electrolyte may include a non-aqueous organic solvent and a lithium salt.

The non-aqueous organic solvent serves as a medium for transmitting ions taking part in the electrochemical reaction of a battery.

The non-aqueous organic solvent may include a carbonate-based, ester-based, ether-based, ketone-based, alcohol-based, or aprotic solvent.

The carbonate-based solvent may include dimethyl carbonate (DMC), diethyl carbonate (DEC), dipropyl carbonate (DPC), methylpropyl carbonate (MPC), ethylpropyl carbonate (EPC), methylethyl carbonate (MEC), ethylene carbonate (EC), propylene carbonate (PC), butylene carbonate (BC), or the like. The ester-based solvent may include methyl acetate, ethyl acetate, n-propyl acetate, dimethyl acetate, methyl propionate, ethyl propionate, decanolide, mevalonolactone, valerolactone, caprolactone, or the like. The ether-based solvent may include dibutyl ether, tetraglyme, diglyme, dimethoxyethane, 2-methyltetrahydrofuran, 2,5-dimethyltetrahydrofuran, tetrahydrofuran, or the like. The ketone-based solvent may include cyclohexanone or the like. The alcohol-based solvent may include ethanol, isopropyl alcohol, and the like and the aprotic solvent may include nitriles such as R-CN (wherein R is a C2 to C20 linear, branched, or cyclic hydrocarbon group, and may include a double bond, an aromatic ring, or an ether bond, and the like); amides such as dimethylformamide; dioxolanes such as 1,3-dioxolane, 1,4-dioxolane, and the like; sulfolanes, or the like.

The organic solvent may be used alone or in a mixture of two or more solvents.

If a carbonate-based solvent is used, cyclic carbonate and the linear carbonate may be used together, and the cyclic carbonate and the linear carbonate may be mixed at a volume ratio of about 1:1 to about 1:9.

The lithium salt dissolved in an organic solvent supplies a battery with lithium ions, operates the rechargeable lithium battery, and improves transportation of the lithium ions between positive and negative electrodes. Examples of the lithium salt include one or more electrolyte salts selected from LiPF₆, LiBF₄, LiSbF₆, LiAsF₆, LiClO₄, LiAlO₂, LiAlCl₄, LiPO₂F₂, LiCl, Lil, LiN(SO₃C₂F₅)₂, Li(FSO₂)₂N (lithium bis(fluorosulfonyl)imide, LiFSI), LiC₄F₉SO₃, LiN(CₓF₂ₓ₊₁SO₂)(C_{y}F_{2y+1}SO₂), where x and y are an integer of 1 to 20, lithium trifluoromethane sulfonate, lithium tetrafluoroethane sulfonate, lithium difluorobis(oxalato)phosphate (LiDFBOP), lithium bis(oxalato) borate (LiBOB).

### [Separator]

A separator may be disposed between the positive electrode and the negative electrode depending on a type of a rechargeable lithium battery. The separator may be formed from polyethylene, polypropylene, polyvinylidene fluoride or multi-layers of such materials having two or more layers and may be a mixed multilayer such as a polyethylene/polypropylene double-layered separator, a polyethylene/polypropylene/polyethylene triple-layered separator, a polypropylene/polyethylene/polypropylene triple-layered separator, and the like.

The separator may include a porous substrate and a coating layer including an organic material, an inorganic material, or a combination thereof on one or both surfaces of the porous substrate.

The porous substrate may be a film formed from polyolefin such as polyethylene and polypropylene, polyester such as polyethylene terephthalate and polybutylene terephthalate, polyacetal, polyamide, polyimide, polycarbonate, polyether ketone, polyarylether ketone, polyetherimide, polyamideimide, polybenzimidazole, polyethersulfone, polyphenylene oxide, a cyclic olefin copolymer, polyphenylene sulfide, polyethylene naphthalate, a glass fiber, TEFLON^{®}, polytetrafluoroethylene, or a copolymer or mixture of two or more of such materials.

The organic material may include a polyvinylidene fluoride-based polymer or a (meth)acryl-based polymer.

The inorganic material may be an inorganic particle selected from Al₂O₃, SiO₂, TiO₂, SnO₂, CeO₂, MgO, NiO, CaO, GaO, ZnO, ZrO₂, Y₂O₃, SrTiO₃, BaTiO₃, Mg(OH)₂, boehmite, or a combination thereof, but the present disclosure is not limited thereto.

The organic material and an inorganic material may be mixed in one coating layer, or a coating layer including an inorganic material may be stacked.

The rechargeable lithium battery may be classified into a lithium-ion battery, a lithium-ion polymer battery, or a lithium polymer battery depending on the types of the separator and the electrolyte. The rechargeable lithium battery may be classified as cylindrical, prismatic, coin-type, or pouch-type depending on its shape, and the battery may be classified into a bulk type or a thin film type depending on its size. The structure and fabrication of such batteries are well-known in the related arts, and, thus, are not described in further detail.

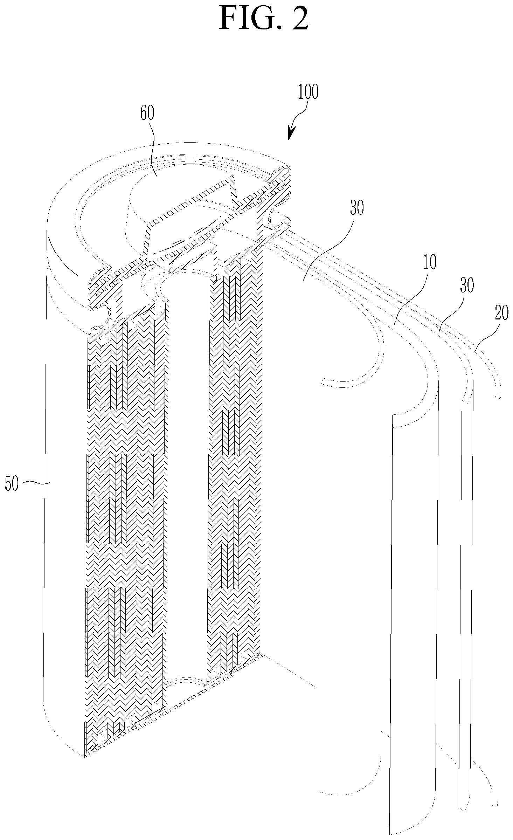

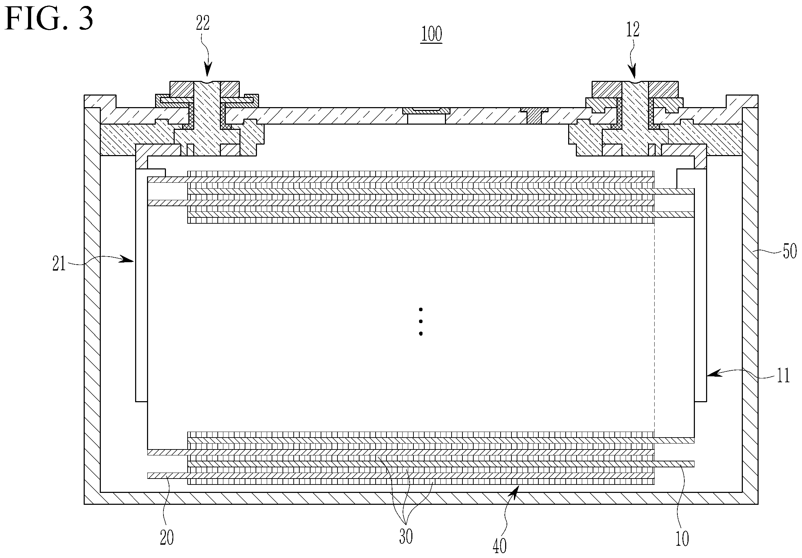

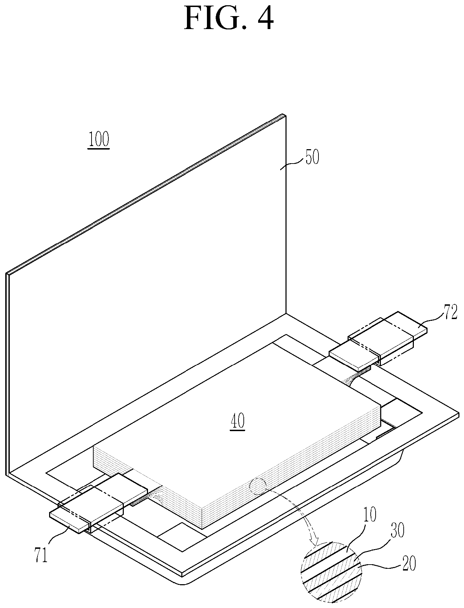

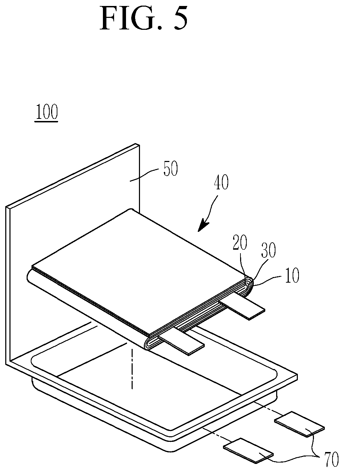

FIG. 2 to FIG. 5 are schematic views illustrating a rechargeable lithium battery according to an embodiment. FIG. 2 shows a cylindrical battery, FIG. 3 shows a prismatic battery, and FIG. 4 and FIG. 5 show pouch-type batteries. Referring to FIGS. 2 to 5, the rechargeable lithium battery 100 may include an electrode assembly 40 including a separator 30 between a positive electrode 10 and a negative electrode 20, and a case 50 in which the electrode assembly 40 is included. The positive electrode 10, the negative electrode 20, and the separator 30 may be impregnated with an electrolyte (not shown). The rechargeable lithium battery 100 may include a sealing member 60 sealing the case 50, as shown in FIG. 2. As shown in FIG. 3, the rechargeable lithium battery 100 may include a positive electrode lead tab 11 and a positive terminal 12, a negative electrode lead tab 21, and a negative terminal 22. As shown in FIG. 4 and FIG. 5, the rechargeable lithium battery 100 may include an electrode tab 70, which may serve as an electrical path for inducing the current formed in the electrode assembly 40 to outside of the battery. For example, the battery 100 may be provided with a positive electrode tab 71 and a negative electrode tab 72.

The rechargeable lithium battery according to an embodiment may be applied to automobiles, mobile phones, and/or various types of electric devices, as non-limiting examples.

The following Examples and Comparative Examples are provided in order to show characteristics of one or more embodiments, but it will be understood that the Examples and Comparative Examples are not to be construed as limiting the scope of the embodiments of the present disclosure. Further, it will be understood that the embodiments are not limited to the particular details described in the Examples and Comparative Example.

### (Example 1)

97.5 wt% of natural graphite and 2.5 wt% of polytetrafluoroethylene were mixed and shaken at a speed of 10,000 rpm speed, thereby inducing fibrillation. This procedure produced a fibrillated product in which a network of a fibrillated polytetrafluoroethylene and natural graphite was prepared.

The prepared fibrillated product was compressed to prepare a dry film.

The dry film was subjected to an oxygen plasma treatment for 1 minute. Then the dry film was subjected to the gas nitriding, which was a chemical vapor deposition by flowing the NH₃ gas at 300 °C for 1 hour to prepare a negative active material layer.

The negative active material layer was laminated on a Cu foil current collector to prepare a negative electrode. The negative active material layer had a thickness of 140 µm. The negative active material layer included the negative active material and the polytetrafluoroethylene with the N-including protection layer, and an amount of the polytetrafluoroethylene that includes the N-including protection layer was 2.5 wt% based on 100 wt% of the negative active material layer.

A half-cell was fabricated using the negative electrode, a lithium metal counter electrode, and an electrolyte. As the electrolyte, an 1M LiPF₆ dissolved in a mixed solvent of ethylene carbonate, ethylmethyl carbonate, and diethyl carbonate (2:1:7 volume ratio) was used.

### (Example 2)

A negative electrode and a half-cell were prepared by the same procedure as in Example 1, except that the oxygen plasma treatment was carried out for 2 minutes. In the prepared negative electrode, the negative active material layer had a thickness of 140 µm. The negative active material layer included the negative active material and the polytetrafluoroethylene with the N-including protection layer, and an amount of the polytetrafluoroethylene that includes the N-including protection layer was 2.5 wt% based on 100 wt% of the negative active material layer.

### (Example 3)

A negative electrode and a half-cell were prepared by the same procedure as in Example 1, except that the oxygen plasma treatment was carried out for 4 minutes. In the prepared negative electrode, the negative active material layer had a thickness of 140 µm. The negative active material layer included the negative active material and the polytetrafluoroethylene with the N-including protection layer, and an amount of the polytetrafluoroethylene that includes the N-including protection layer was 2.5 wt% based on 100 wt% of the negative active material layer.

### (Example 4)

A negative electrode and a half-cell were prepared by the same procedure as in Example 1, except that the gas nitriding was carried out for 2 hours. In the prepared negative electrode, the negative active material layer had a thickness of 140 µm. The negative active material layer included the negative active material and the polytetrafluoroethylene with the N-including protection layer, and an amount of the polytetrafluoroethylene that includes the N-including protection layer was 2.5 wt% based on 100 wt% of the negative active material layer.

### (Example 5)

A negative electrode and a half-cell were prepared by the same procedure as in Example 1, except that the gas nitriding was carried out for 4 hours. In the prepared negative electrode, the negative active material layer had a thickness of 140 µm. The negative active material layer included the negative active material and the polytetrafluoroethylene with the N-including protection layer, and an amount of the polytetrafluoroethylene that includes the N-including protection layer was 2.5 wt% based on 100 wt% of the negative active material layer.

### (Comparative Example 1)

97.5 wt% of natural graphite and 2.5 wt% of polytetrafluoroethylene were mixed and shaken at a speed of 10,000 rpm speed, thereby inducing fibrillation. This procedure produced a fibrillated product in which a network of a fibrillated polytetrafluoroethylene and natural graphite was prepared.

The prepared fibrillated product was compressed to prepare a dry film.

The dry film was used as a negative active material layer to laminate on the Cu foil current collector, thereby preparing a negative electrode. The negative active material layer had a thickness of 140 µm.

A half-cell was fabricated by the same procedure as in Example 1, except that the negative electrode according to this Comparative Example 1 was used.

### (Comparative Example 2)

Natural graphite was subjected to the oxygen plasma treatment for 1 minute, and gas nitriding by chemical vapor deposition by flowing NH₃ gas at 300 °C for 1 hour, thereby preparing a negative active material.

97.5 wt% of the prepared negative active material and 2.5 wt% of polytetrafluoroethylene were mixed, and the resulting mixture was compressed to prepare a dry film.

The dry film was used as a negative active material layer to laminate on the Cu foil current collector, thereby preparing a negative electrode. The negative active material layer had a thickness of 140 µm.

A half-cell was fabricated by the same procedure as in Example 1, except that the negative electrode according to this Comparative Example 2 was used.

### Experimental Example 1) Evaluation of initial efficiency

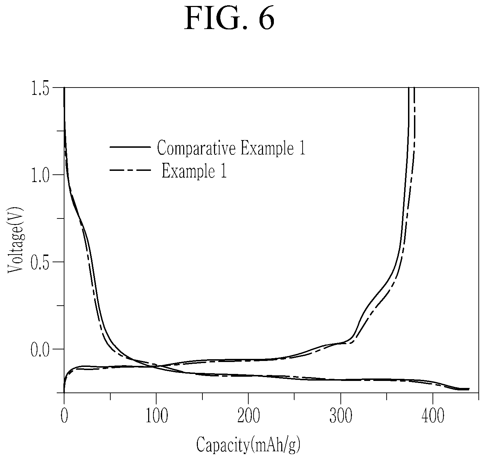

The half-cells according to Examples 1 to 5, and Comparative Examples 1 and 2 were charged and discharged once at 0.1 C. The charge and discharge characteristics are shown in FIG. 6. The initial efficiency, which was a ratio of discharge capacity relative to charge capacity, was calculated. The initial efficiency are shown in Table 1.

**Table 1**

| | Initial efficiency (%) |
|---|---|
| Example 1 | 87.9 |
| Example 2 | 87.6 |
| Example 3 | 87.2 |
| Example 4 | 87.8 |
| Example 5 | 87.7 |
| Comparative Example 1 | 86.1 |
| Comparative Example 2 | 86.3 |

As shown in Table 1, Examples 1 to 5 exhibited greater initial efficiency than Comparative Examples 1 and 2. Comparative Example 2, in which graphite was subjected to perform oxygen plasma treatment and nitriding, exhibited similar efficiency to Comparative Example 1. From these results, it can be seen that if only graphite negative active material is subject to oxygen plasma treatment and nitriding, the effect for improving efficiency may not be obtained.

### Experimental Example 2) Evaluation of cycle-life and coulombic efficiency

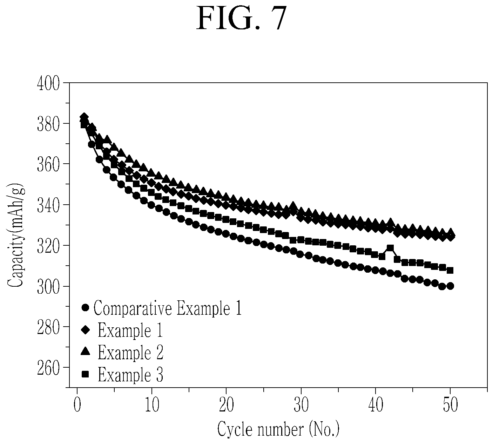

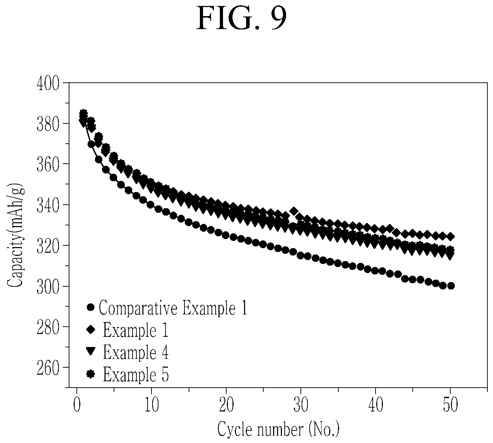

The half-cells according to Examples 1 to 5, and Comparative Examples 1 to 2 were charged and discharged at 0.2 C for 50 cycles. The discharge capacity at each cycle was measured. Among these results, the results of Examples 1 to 3 and Comparative Example 1 are shown in FIG. 7 and the results of Examples 1, 4, and 5, and Comparative Example 1 are shown in FIG. 9, respectively. As shown in FIG. 7 and FIG. 9, the oxygen plasma treatment and the gas nitriding decrease the capacity loss. From these results, it can be seen that the cycle-life characteristic was improved.

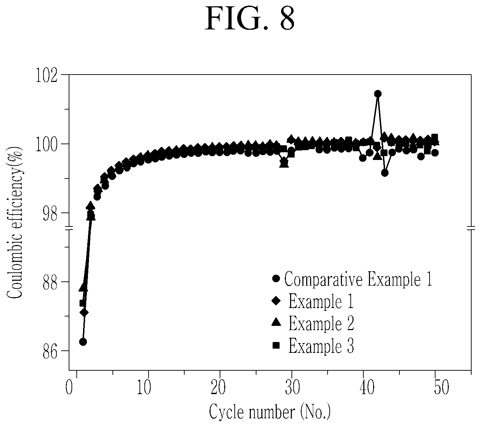

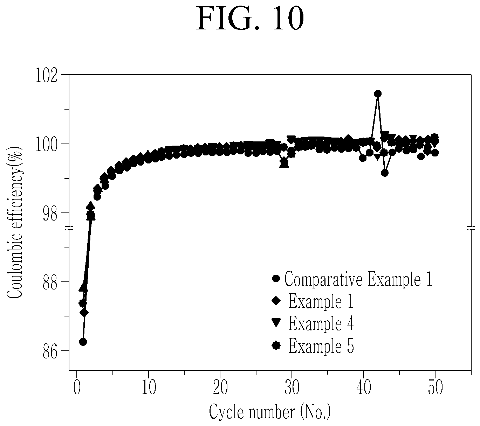

The half-cells according to Examples 1 to 5 and Comparative Examples 1 to 3 were charged to 0.5 mAh/cm² at 2 C (1 mA/cm²) and discharged for 50 cycles to measure a coulombic efficiency. Among these results, the results of Examples 1 to 3 and Comparative Example 1 are shown in FIG. 8 and the results of Examples 1, 4, and 5, and Comparative Example 1 are shown in FIG. 10. As shown in FIG. 8 and FIG. 10, the oxygen plasma treatment and gas nitriding have the effect of maintaining coulombic efficiency.

### Experimental Example 3) Charge transfer resistance (R_{ct})

The half-cells according to Examples 1 to 5, and Comparative Examples 1 and 2 were charged and discharged under the SOC50 condition (charged to be 50% of charge capacity based on 100% of entire battery charge capacity, which is 50% discharged in a discharge state), and the resistance was measured. The measured resistance is a charge transfer resistance (R_{ct}), and the results are shown in Table 2, as R_{ct}.

**Table 2**

| | R_{ct} (ohms) |
|---|---|
| Comparative Example 1 | 13.47 |
| Comparative Example 2 | 11.65 |
| Example 1 | 6.64 |
| Example 2 | 5.35 |
| Example 3 | 10.57 |
| Example 4 | 10.32 |
| Example 5 | 10.46 |

As shown in Table 2, the charge transfer resistances of Examples 1 to 5 is lower than the charge transfer resistances of Comparative Examples 1 and 2.

### Experimental Example 4) Evaluation of X-ray Photoelectron Spectroscopy (XPS)

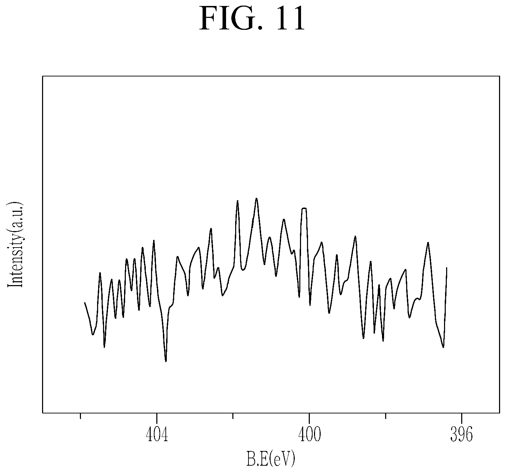

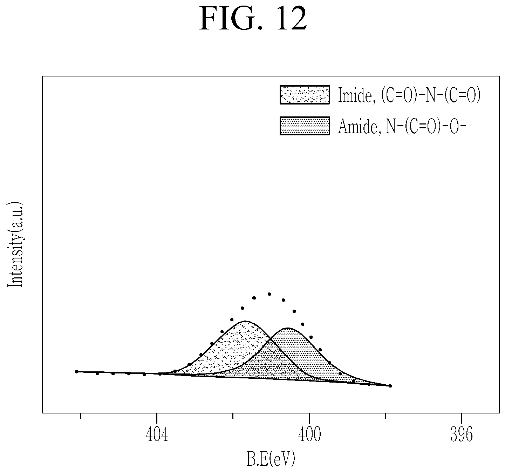

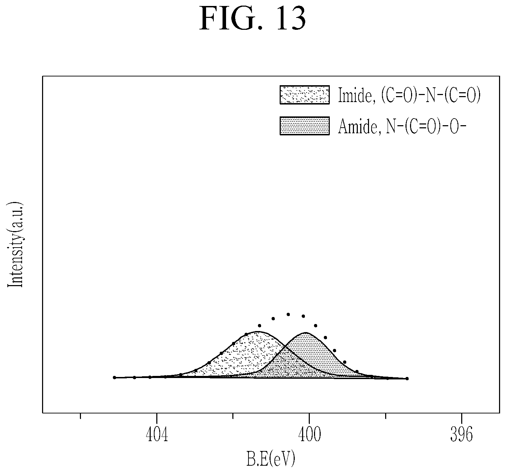

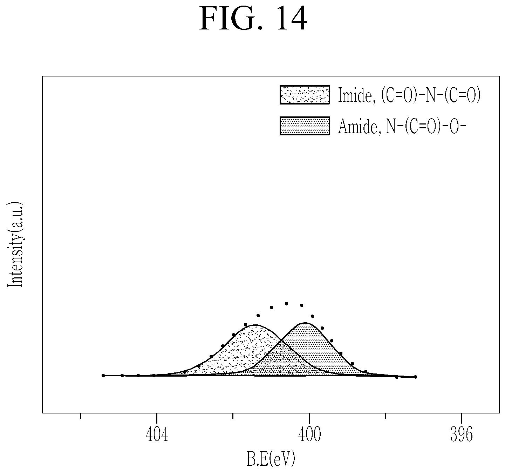

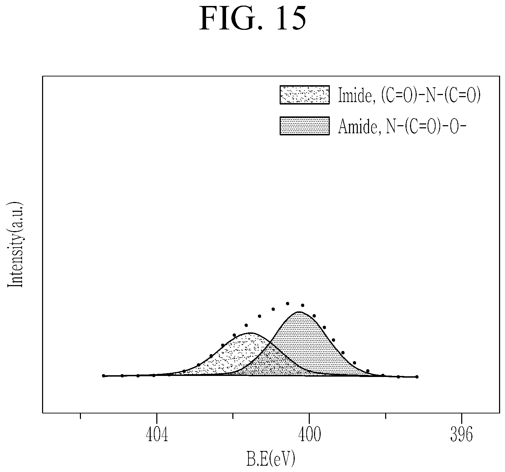

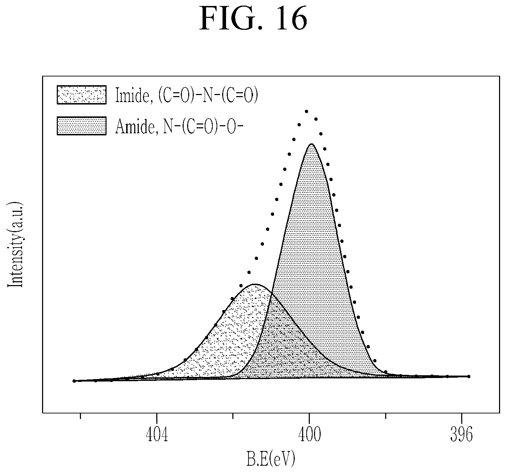

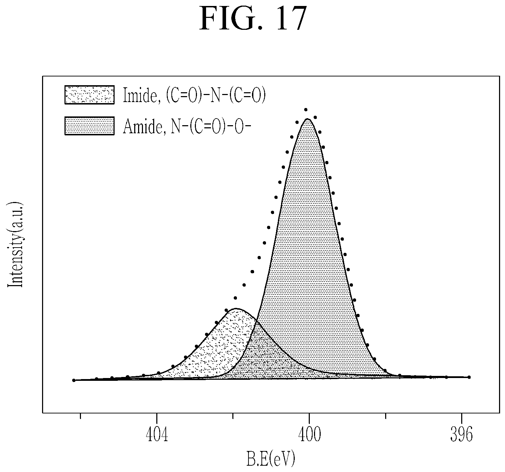

XPS of the negative electrodes according to Examples 1 to 5 and Comparative Examples 1 and 2 was evaluated. Among the results, the XPS analysis of Comparative Example 1 is shown in FIG. 11. Comparative Example 1 did not undergo nitriding, and, thus, any peaks related to nitrogen did not appear, and the peaks shown in FIG. 11 were identified as a noise result. The result of Comparative Example 2 is shown in FIG. 12. The result of Example 1 is shown in FIG. 13, the result of Example 2 is shown in FIG. 14, the result of Example 3 is shown in FIG. 15, the result of Example 4 is shown in FIG. 16, and the result of Example 5 is shown in FIG. 17.

Comparing FIG. 12 to FIG. 17, with the oxygen plasma treatment and gas nitriding, a peak appeared at a binding energy of 399.0 eV to 400 eV and a peak appeared at a binding energy of 400.4 eV to 401 eV. Thus, it can be seen that the amide group and the imide group were included in the surface of the negative active material. In FIG. 11 to FIG. 17, B.E. represents a binding energy and the dotted graph represents the areas which are obtained summing peak areas corresponding to an amide group and an imide group.

While this disclosure has been described in connection with what is presently considered to be practical example embodiments, it is to be understood that the disclosure is not limited to the disclosed embodiments. On the contrary, the disclosure includes various modifications and equivalent arrangements. Therefore, the aforementioned embodiments should be understood to be examples but not limiting the present disclosure in any way.

## Claims

1. A negative electrode for a rechargeable lithium battery, the negative electrode comprising:
a dry negative active material layer comprising a negative active material and polytetrafluoroethylene binder that includes a N-including protection layer.

2. The negative electrode for a rechargeable lithium battery as claimed in claim 1, wherein the N-including protection layer comprises one or more of elemental C, O, and H.

3. The negative electrode for a rechargeable lithium battery as claimed in claim 1 or claim 2, wherein the dry negative active material layer further includes one or more of a non-fibrillated binder of carboxymethyl cellulose, a styrene-butadiene rubber, polyvinylidene fluoride, and polyacrylic acid.

4. The negative electrode for a rechargeable lithium battery as claimed in any one of claims 1 to 3, wherein the polytetrafluoroethylene binder is fibrillated.

5. The negative electrode for a rechargeable lithium battery as claimed in any one of claims 1 to 4, wherein the polytetrafluoroethylene binder comprises a N-including functional group, optionally wherein the N-including functional group is one or more of imide group, an amide group, an amine group, and a nitrile group.

6. The negative electrode for a rechargeable lithium battery as claimed in any one of claims 1 to 5, wherein, when measuring the negative electrode using XPS, a peak appears at a binding energy of about 399.0 eV to about 400 eV and at a binding energy of about 400.4 eV to 401 eV, or a binding every of about 397 eV to 400.2 eV.

7. The negative electrode for a rechargeable lithium battery as claimed in any one of claims 1 to 6, wherein an amount of the polytetrafluoroethylene binder including the N-including protection layer is about 0.1 wt% to about 20.0 wt% based on 100 wt% of the negative active material layer.

8. The negative electrode for a rechargeable lithium battery as claimed in any one of claims 1 to 7, wherein:
(i) the negative active material comprises a N-including protection layer; and/or
(ii) the dry negative active material layer has a thickness of about 10 µm to about 400 µm; and/or
(iii) the dry negative active material layer further comprises a non-fibrillated binder.

9. A method of preparing a negative electrode for a rechargeable lithium battery, the method comprising:
mixing a negative active material with polytetrafluoroethylene and fibrillating the mixture to prepare a fibrillated product;
compressing the fibrillated product to prepare a dry film;
subjecting the dry film to a vapor reaction to prepare a negative active material layer,
providing the negative active material layer on a current collector.

10. The method of preparing the negative electrode for the rechargeable lithium battery as claimed in claim 9, wherein the vapor reaction is at least one of chemical vapor deposition, physical vapor deposition, atomic layer deposition, and plasma treatment.

11. The method of preparing the negative electrode for the rechargeable lithium battery as claimed in claim 9 or claim 10, wherein the vapor reaction comprises gas plasma treatment and gas nitriding.

12. The method of preparing the negative electrode for the rechargeable lithium battery as claimed in claim 11, wherein the gas plasma treatment is an oxygen plasma treatment.

13. The method of preparing the negative electrode for the rechargeable lithium battery as claimed in claim 11 or claim 12, wherein the gas nitriding is a chemical vapor deposition with NH₃ gas.

14. The method of preparing the negative electrode for the rechargeable lithium battery as claimed in any one of claims 11 to 13, wherein:
(i) the gas nitriding is carried out at a temperature of about 50 °C to about 600 °C; and/or
(ii) the gas plasma treatment is carried out for about 1 second to about 120 minutes; and/or
(iii) the gas nitriding is carried out for about 1 minute to about 6 hours.

15. A rechargeable lithium battery comprising:
a negative electrode of any one of claims 1 to 8;
a positive electrode; and
a non-aqueous electrolyte.
